# EUROPEAN PATENT APPLICATION

(11) **EP 4 350 753 A1**
(43) Date of publication of application: **10.04.2024**
(21) Application number: 22199673.9
(22) Date of filing: 04.10.2022
(51) Int. Cl.: H01L 23/00, H05K 5/06

(54) **ELECTRONIC DEVICE WITH THREE-DIMENSIONALLY NON-PLANAR MOLD BODY HAVING ELECTRIC ENTITY THEREIN AND WITH ELECTRICALLY CONDUCTIVE STRUCTURE THEREON**

(71) Applicant: AT & S Austria Technologie & Systemtechnik Aktiengesellschaft, 8700 Leoben-Hinterberg (AT)
(72) Inventor: Gavagnin, Marco, 8700 Leoben (AT); Schulz, Gernot, 8020 Graz (AT); Krivec, Thomas, 8740 Zeltweg (AT)
(74) Representative: Dilg, Haeusler, Schindelmann Patentanwaltsgesellschaft mbH

(57) **Abstract**

An electronic device (100) which comprises a three-dimensionally non-planar mold body (102) defining at least part of one of a non-planar side surface (104) and an opposed non-planar side surface (106) of the electronic device (100), an electrically conductive structure (114) provided on one of said non-planar side surface (104) and said opposing non-planar side surface (106), and at least one electric entity (108) at least partially inside of the three-dimensionally non-planar mold body (102).

## Description

### Field of the Invention

The invention relates to an electronic device and to a method of manufacturing an electronic device.

### Technological Background

In the context of growing product functionalities of component carriers equipped with one or more components and increasing miniaturization of such components as well as a rising number of components to be connected to the component carriers such as printed circuit boards, increasingly more powerful array-like components or packages having several components are being employed, which have a plurality of contacts or connections, with ever smaller spacing between these contacts. In particular, component carriers shall be mechanically robust and electrically reliable so as to be operable even under harsh conditions.

Another technology for forming electronic devices is molding. In a molded package, an electronic component may be encapsulated in a mold compound.

### Summary of the Invention

There may be a need to provide a freely designable three dimensionally non-planar electronic device with electronic functionality.

According to an exemplary embodiment of the invention, an electronic device is provided which comprises a three-dimensionally non-planar mold body defining at least part of one of a non-planar side surface and an opposed non-planar side surface of the electronic device, an electrically conductive structure provided on (in particular as an elevated structure with regard to adjacent material) one of said non-planar side surface and said opposing non-planar side surface, and at least one electric entity at least partially inside of the three-dimensionally non-planar mold body.

According to another exemplary embodiment of the invention, a method of manufacturing an electronic device is provided, wherein the method comprises forming a three-dimensionally non-planar mold body defining at least part of one of a non-planar side surface and an opposing non-planar side surface of the electronic device, forming an electrically conductive structure on (in particular on top of and protruding beyond) one of said non-planar side surface and said opposing non-planar side surface, and providing, preferably embedding, at least one electric entity at least partially inside of the three-dimensionally non-planar mold body.

In the context of the present application, the term "electronic device" may particularly denote a member or an apparatus configured for providing an electronic functionality. Such an electronic device may be a stand-alone device providing the electronic functionality alone or may be a device cooperating with at least one further electronic device for providing the electronic functionality together.

In the context of the present application, the term "mold body" may particularly denote a physical structure comprising a mold compound. For instance, such a mold compound may comprise a resin matrix with filler particles therein. The resin matrix may provide electric insulation, whereas the filler particles may functionalize the mold body. Such a functionalization may be a reduction of density, an enhancement of thermal conductivity, a cost reduction, etc. Moreover, the filler particles may provide stability. While the resin may have insulating properties, it may, for example in case of laser direct structuring (LDS), contain an activator for electroless plating to realize tracks. The resin may take the form of the mold when it is softened (for example with heat) and hardens when it cools down. For example, a mold body may be formed in a mold tool in which a flowable precursor of the mold body may be inserted and cured for hardening the mold body, in particular by supplying thermal energy, electromagnetic irradiation, in particular UV-light, and/or pressure. For instance, the mold body may be a curved plate, for instance configured as casing member. However, the mold body may also be a bulk structure. It is possible that the mold body has one or more exterior notches and/or one or more interior through holes. The mold body may have a constant thickness or may have a varying thickness. For example, the mold body may be created by transfer molding. It may also be possible to use more than one mold compound to create the mold body (for example for double injection molding or multi-shot injection molding).

In the context of the present application, the term "three dimensionally non-planar" may particularly denote a curved exterior shape or outline of the mold body including curved surface regions along all three mutually perpendicular dimensions of a three-dimensional Cartesian coordinate system. For instance, a three dimensionally non-planar mold body may have a curved surface in all three spatial dimensions. Such a three dimensionally non-planar mold body may comprise at least one concave surface portion and/or at least one convex surface portion and/or at least one combined partially concave and partially convex surface portion. A three dimensionally non-planar mold body may have a shape which deviates strongly from a planar structure, a flat structure or a substantially cuboid structure. By "non-planar", it may be meant in particular that the curved exterior surface of the mold body may be composed of at least two mutually bent portions, preferably planar portions or adjacent curved-planar portions. Additionally or alternatively, the term "non-planar" may mean that the mold body can comprise a curved body, preferably extending along a continuous curve or along several curve portions (which may be connected one to each other and which may have a circular evolution so that at least two discontinuous circular portions are distinguishable). For example, a three-dimensionally non-planar mold body may be a three-dimensionally curved mold body.

In the context of the present application, the term "non-planar side surface and an opposing non-planar side surface" may particularly denote two non-planar (for instance angled or curved) surface portions of the mold body facing away from each other, for example facing towards different spatial volumes in a surrounding of the electronic device. For instance, the non-planar side surface can be an internally curved side surface, for instance a concave side surface. The opposed non-planar side surface can be an externally curved side surface, for instance a convex side surface, or vice versa.

In the context of the present application, the term "main surface" of a body may particularly denote one of two largest opposing surfaces of the body. The main surfaces may be connected by circumferential side walls. The thickness of a body having two opposing main surfaces may be defined by the distance between the two opposing main surfaces.

In the context of the present application, the term "electrically conductive structure on non-planar side surface" may particularly denote an at least partially metallic physical structure at least partially protruding from said side surface rather than being fully embedded therein. For example, an electrically conductive structure on a non-planar side surface may be an electrically conductive trace, wiring and/or pad extending from and above the side surface so as to have at least one exposed side wall portion.

In the context of the present application, the term "electric entity" may particularly denote any physical structure configured for carrying and/or processing electricity. For instance, such an electric entity may be or may comprise an electrically conductive trace, wiring and/or pad. It is also possible that an electric entity is or comprises an electronic component, such as a semiconductor chip, a capacitor member, a PCB or a module.

In the context of the present application, the term "at least partially inside of three-dimensionally non-planar mold body" may particularly denote that the at least one electric entity is at least partially embedded in the mold body, i.e. is located at least partially therein. In this context, "embedded" may particularly mean fully embedded or only partially embedded, but not entirely protruding from the mold body. Hence, the at least one entity may be inserted or accommodated at least partially within said mold body rather than fully protruding therefrom. For example, an electric entity inside the mold body may have side walls being at least partially buried inside of the mold body.

According to an exemplary embodiment of the invention, an electronic device has a three-dimensionally non-planar mold body forming at least part of at least one non-planar side surface of the electronic device. An electrically conductive structure (such as a wiring trace) is formed on and thereby protrudes beyond said at least one non-planar side surface. Moreover, at least one electric entity may be embedded partially or entirely in the mold body. Advantageously, such an electronic device may be freely shaped in the three-dimensional space in accordance with a desired application (for instance to mechanically fit into a three dimensional accommodation volume of another apparatus while providing an electronic function therein). Hence, at least partially within the mold body and at least partially thereon, said electric elements may be formed. Hence, a three dimensionally shaped molded interconnect device with sophisticated electric functionality therein and thereon may be provided. Thus, a freely designable three dimensionally non-planar electronic device can be equipped with even sophisticated electronic functionality.

### Detailed Description of Exemplary Embodiments

In the following, further exemplary embodiments of the electronic device and the method will be explained.

In an embodiment, the at least one electric entity comprises at least one electronic component, in particular at least one semiconductor chip and/or at least one component carrier.

In the context of the present application, the term "electronic component" may particularly denote a device or member fulfilling an electronic task. Such an electronic component may be an active component such as a semiconductor chip comprising a semiconductor material, in particular as a primary or basic material. The semiconductor material may for instance be a type IV semiconductor such as silicon or germanium, or may be a type III-V semiconductor material such as gallium arsenide. In particular, the semiconductor component may be a semiconductor chip such as a naked die or a molded die. At least one integrated circuit element may be monolithically integrated in such a semiconductor chip. However, the component can also be a passive component or another body with electronic functionality. By at least partially embedding an electronic component in the mold body, the electronic component may be reliably protected with regard to the environment.

In the context of the present application, the term "component carrier" may particularly denote any support structure which is capable of accommodating, directly or indirectly, one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above-mentioned types of component carriers. Hence, the at least partially embedded at least one electric entity may be an embedded component carrier, such as a PCB or an IC substrate. Preferably, such an at least partially embedded component carrier may be a high density integration (HDI)-type component carrier. When a plurality of component carriers are provided at least partially embedded in the mold body of the electronic device, said component carriers may be electrically coupled with each other by the electrically conductive structure on the mold body and/or by at least one further electric entity which is at least partially embedded in the mold body and being embodied as electrically conductive layer structure.

In an embodiment, the at least one electric entity comprises at least one module. A module may be a component carrier (such as a printed circuit board or an integrated circuit substrate) or a mold compound having one or more components mounted thereon and/or therein. Such one or more components may comprise one or more electronic components and/or one or more thermal components, like a copper block, providing a thermal function such as cooling.

In an embodiment, the at least one electronic component is entirely embedded in an interior of the electronic device. Hence, the electronic component can be arranged completely inside of the mold body and/or a further dielectric structure without having direct access to an exterior surface. This may protect the electronic component mechanically (in particular against shocks) and electrically (for instance for protecting against shortage caused by moisture or the like).

However, it is also possible that the at least one electronic component is embedded only partially in an interior of the electronic device. Moreover, it is possible that a surface of the component, being embedded partially or entirely, is exposed.

In an embodiment, the electrically conductive structure is electrically coupled with the at least one electronic component. Thus, the electrically conductive structure may couple the at least partially embedded electronic component with an electronic periphery. In particular, electric power and/or electric signals may be transported by the electrically conductive structure to the electronic component and/or away from the electronic component.

In an embodiment, the at least one electric entity comprises at least one electrically conductive layer structure, in particular a plurality of stacked electrically conductive layer structures. As an alternative to stacked electrically conductive layer structures, they may also be all on the same level. In the context of the present application, the term "layer structure" may particularly denote a continuous layer, a patterned layer or a plurality of non-consecutive islands within a common plane. For instance, one or more electrically conductive layer structures of the at least one electric entity may comprise at least one wiring structure (such as an electric trace), at least one metallic terminal (for instance a pad) and/or at least one vertical through connection (such as a metallic via or a metal pillar). The at least one electric entity may thereby accomplish electric coupling and/or electric signal transmission in an interior of the mold body.

In an embodiment, the electrically conductive structure extends up to an exposed surface of the electronic device. The exposed surface can be at an internal position (for example at a concave surface portion of the mold body) or at an external position (for example at a convex surface portion of the mold body) of the electronic device or its mold body. When the electrically conductive structure extends up to an exposed surface of the electronic device, it can form at least one external electric contact for electrically coupling the electronic device to another electronic member or apparatus.

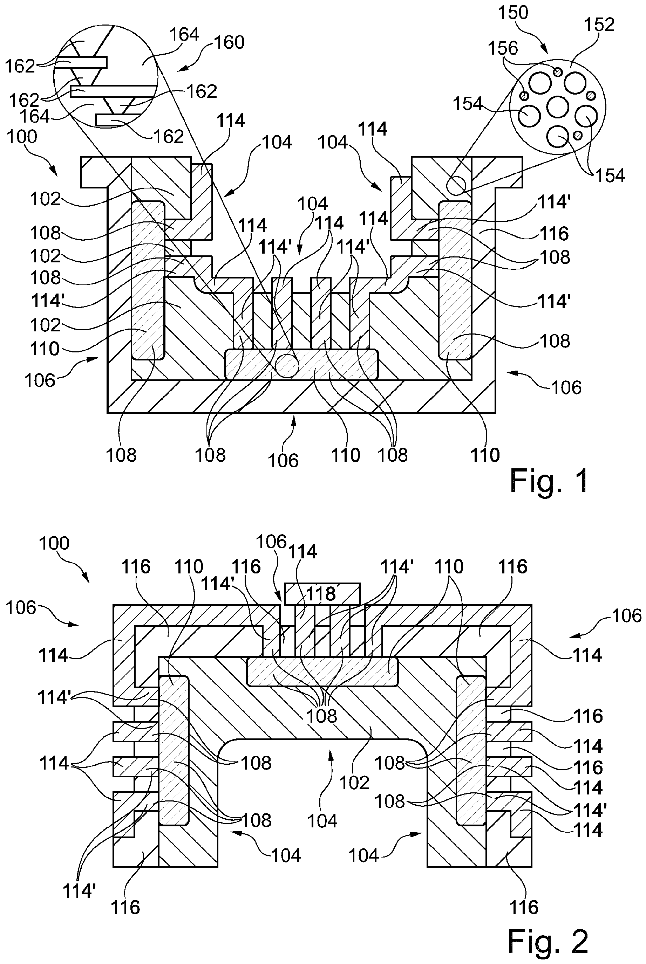

In an embodiment, the non-planar side surface has a concave shape. In particular, concave may mean a surface having an outline that curves inwards, such as for example the interior of a circle or sphere. In such an embodiment, the mold body may define at least part of a concave inwardly curved surface (see for example Figure 1 or Figure 2).

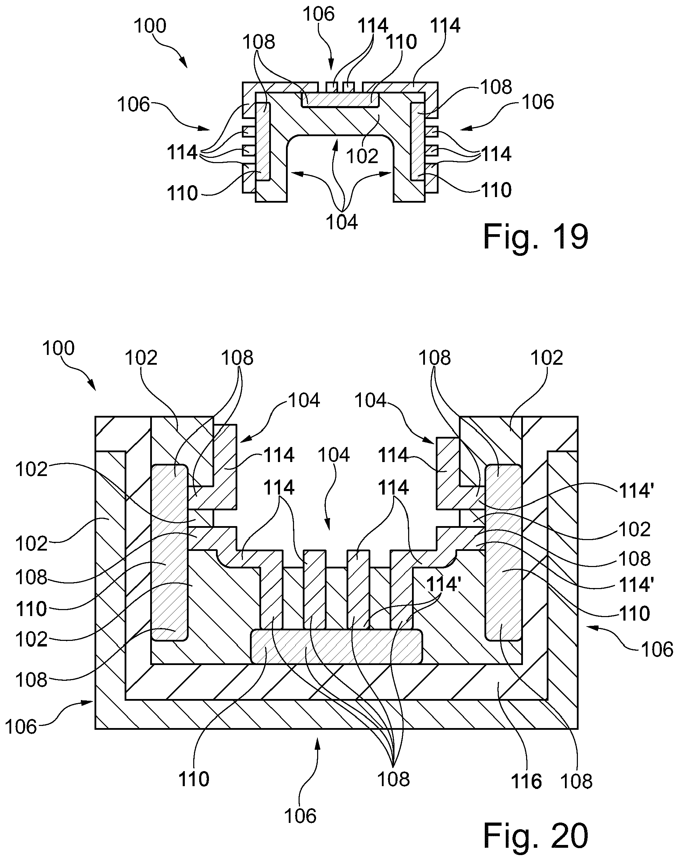

In an embodiment, the opposed non-planar side surface has a convex shape. In particular, convex may mean a surface having an outline that curves outwards, such as for example the exterior of a circle or sphere. In such an embodiment, the mold body may define at least part of a convex outwardly curved surface (see for example Figure 20).

However, it is also possible that the non-planar side surface and the opposed non-planar side surface are both convex or both concave.

In an embodiment, the electronic device comprises a further dielectric structure. Apart from the mold body, at least one further dielectric structure may form an integral part of a three dimensionally curved electronic device. This may further improve the freedom of design to specifically configure the electronic device to comply with an intended function.

In an embodiment, the further dielectric structure is a dielectric sheet or laminate, in particular an organic sheet or laminate, or a further mold body. In particular, a dielectric multi-layer laminate may be an electrically insulating structure composed of different sheets (for instance prepreg sheets or resin sheets) which may be interconnected by the application of pressure, electromagnetic irradiation, in particular UV-light, and/or heat. For example, a respective dielectric sheet may comprise resin and optionally reinforcing particles, such as glass fibers. For instance, a dielectric sheet may comprise initially at least partially uncured resin which is cured when being connected with the mold body. During curing, such a resin may undergo cross-linking or polymerization.

For example, the further dielectric structure may be a laminated layer stack comprising at least two electrically insulating layer structure. Optionally, at least one electrically conductive layer structure (for example comprising at least one patterned metal layer, such as a copper foil or deposited copper layer, and/or at least one vertical through connection such as a metallic via or a metal pillar) may be integrated in said stack.

In another embodiment, the further dielectric structure may be a further mold body. The above mentioned mold body and the further mold body may be made of different materials (such as different resins and/or different filler particles) or may be made of the same material. The above mentioned mold body and the further mold body may be created in different mold processes, i.e. one after the other.

For instance, the further dielectric structure embodied as a dielectric laminate may be or may form part of an embedded stack or an embedded component carrier, such as a PCB or an IC substrate.

In an embodiment, the further dielectric structure is connected with the mold body with direct physical contact. This may make it possible to keep the electronic device compact, since the further dielectric structure and the mold body may be connected without intermediate body in between. Furthermore, this may make it possible to embed an embedded electronic entity, such as an electronic component, partially by the mold body and partially by the further dielectric structure. Hence, mold body and further dielectric structure may cooperate for embedding. For instance, the direct physical contact between mold body and further dielectric structure may be created during molding, which may also cure the further dielectric structure.

In an embodiment, the further dielectric structure has rigid-flexible properties or semi-flexible properties. Different types of partially flexible and partially rigid dielectric structures exist. A "rigid-flex dielectric structure" comprises a fully flexible portion, for instance made of polyimide, being a different material than stiffer dielectric material of a rigid portion. Another type of partially flexible and partially rigid dielectric structure is a "semi-flex dielectric structure" which is a dielectric structure in which its semi-flexible portion may comprise the same dielectric (for instance FR4) material as a rigid portion, so that bendability of the semi-flexible portion only results from the reduced thickness in the semi-flexible portion. By implementing rigid-flexible properties and/or semi-flexible properties in the electronic device, the electronic device may be easily adapted to a special configuration at a destination (for instance during integration in a housing of another apparatus) where the electronic device shall be mounted or used. Thus, rigid-flexible or semi-flexible dielectric structures may significantly simplify an adaptation of a manufactured electronic device to an intended application. In particular, a rigid flex PCB may have longer extensions along two walls (in case of Figure 20 the bottom wall and the side wall).

In an embodiment, the further dielectric structure comprises a thermoplastic material. In the context of the present application, the term "thermoplastic material" may particularly denote a plastic polymer material that becomes pliable or moldable at a certain elevated temperature and solidifies upon cooling. Thermoplastics differ from thermosetting polymers which form irreversible chemical bonds during the curing process. A further dielectric structure comprising thermoplastic material may improve the flexibility of freely designing the shape of a three dimensionally curved electronic device.

In an embodiment, the electronic device comprises at least one surfacemounted component being surface mounted on or above the further dielectric structure. In addition to at least one embedded electric entity, the electronic device may also comprise one or more SMD (surface mounted device) components, such as semiconductor chips. For example semiconductor power chips generating a considerable amount of heat during operation may be surface mounted on the further dielectric structure in order to allow an efficient dissipation of heat towards the environment.

In an embodiment, the further dielectric structure defines at least part of the other one, in particular only of the other one, of the non-planar side surface and the opposed non-planar side surface of the electronic device. In other words, one of the non-planar side surfaces may be defined at least partially by the mold body and the other one of the non-planar side surfaces may be defined at least partially by the further dielectric structure. Corresponding embodiments are shown in Figure 1 and Figure 2.

It is however also possible that both non-planar side surfaces are defined at least partially by the mold body, see for example Figure 20.

What concerns the surfaces of the dielectric structure, some portions thereof may be rough, whereas other portions may be smooth, in particular depending on the application and/or integration target of the electronic device. In particular when considering a housing or casing itself as the electronic device with the functional structure integrated, it may make sense to specify surface properties, for instance what concerns micro- and/or nano-properties, but also macroscopically, haptically (for instance for a soft touch) and/or functional (for example antibacterial).

In an embodiment, the electrically conductive structure defines at least part of only one of the non-planar side surface and the opposed non-planar side surface of the electronic device. In particular, said only one non-planar side surface may be defined partially by the electrically conductive structure and partially by the mold body (see for example Figure 1). Alternatively, said only one non-planar side surface may be defined partially by the electrically conductive structure and partially by the further dielectric structure (compare for instance Figure 2).

In an embodiment, the mold body comprises a resin and filler particles, and optionally palladium and/or silver. The resin may provide the electric insulating property and the mechanical stability of the mold body. The filler particles may allow to tune the functional properties of the mold body, for instance its thermal behavior. A palladium or silver content of the mold compound may make it possible that electrically conductive material can be applied directly on the mold compound. This can be done in a two-component or three-component co-injection molding stage, applying the palladium or silver comprising material (which is quite expensive) just where finally copper lines should appear. In other words, palladium and/or silver may ensure that the mold body is configured as a directly plateable mold compound. This may include a treatment stage by applying heat and/or electromagnetic irradiation (particularly laser light). This means that a metallic material such as copper can be applied by plating directly to the mold body, in particular without the need of forming a metallic seed layer by electroless plating (for instance sputtering or a chemical process) before electroplating (for instance galvanic plating). An activation stage may be sufficient.

In an embodiment, the electronic device is substantially U-shaped (see for example Figure 1). However, a three dimensionally curved electronic device according to an exemplary embodiment of the invention may also have another shape, such as a substantial S-shape, a substantial L-shape, a substantial V-shape, a substantial X-shape, a substantial Z-shape or any other complex three dimensionally curved non-planar shape.

In an embodiment, the three-dimensionally non-planar mold body defines at least part of only one of the non-planar side surface and the opposed non-planar side surface of the electronic device. In such an embodiment, the respectively other non-planar side surface it is not even partially defined by the mold body, but for instance by the further dielectric structure and/or by the electrically conductive structure.

Alternatively, both non-planar side surfaces may be defined substantially or even entirely by the mold body. The further dielectric structure can then be embedded in the three-dimensionally non-planar mold body (see for instance Figure 20).

In an embodiment, the electrically conductive structure is provided only on one of said non-planar side surface and said opposing non-planar side surface. For example, the respectively other non-planar side surface may then be for example entirely dielectric (either defined by the mold body, see Figure 2, or by the further dielectric structure, see Figure 1).

In an embodiment, the electrically conductive structure is provided on and protruding beyond said one of said non-planar side surface and said opposing non-planar side surface. Thus, the electrically conductive structure may be an elevated structure being raised with respect to the respective non-planar side surface of the mold body and/or of the further dielectric structure.

In an embodiment, the method comprises inserting the at least one further dielectric structure in a three-dimensionally non-planar manner in a mold tool, and thereafter forming the mold body in the mold tool by molding on the further dielectric structure. Advantageously, such a process may allow to shape and/or cure the further dielectric structure and the mold body in a common process. Hence, such an approach is highly efficient and accelerates the manufacturing process.

In an embodiment, the method comprises inserting the at least one electric entity in the mold tool, in particular on the at least one further dielectric structure, before the molding. Consequently, the interconnection of the at least one electric entity and the mold body, and preferably also of the further dielectric structure, may be executed in one common process. This ensures a proper mutual interconnection and renders the manufacturing process quick and simple.

In an embodiment, the method comprises inserting the at least one electric entity in a mold tool, and thereafter forming the mold body in the mold tool by molding on the at least one electric entity. In particular, the method may comprise inserting a plurality of electric entities, in particular a plurality of electronic components, in different orientations in the mold tool, and thereafter forming the mold body in the mold tool by molding on the plurality of electric entities, preferably without providing a further dielectric structure during this process. Molding such an arrangement of one or more preferably componenttype electric entities in a mold tool further improves the efficiency of the manufacturing process.

In an embodiment, the method comprises, after the molding, forming at least one further electric entity, in particular at least one electrically conductive layer structure, on at least one of the mold body and the at least one electric entity. Thus, processing of the electronic device or a preform thereof may be continued after completing the molding process. The mold body, optionally already provided with at least one electric entity and/or at least one electrically conductive structure, may be further processed for refining its functionality.

In an embodiment, the method comprises structuring the mold body and/or the further dielectric structure, in particular by laser direct structuring. By irradiating the mold body and/or the further dielectric structure with a laser beam and moving the laser beam along the mold body and/or the further dielectric structure in accordance with a predefined trajectory, a patterning process for defining grooves to be filled with metal for forming at least one partially embedded electric entity may be significantly simplified. In particular, a laser source can be used to expose terminals of an embedded component carrier or electronic component. In case the mold body contains activator particles, such as palladium, silver, etc., the laser beam may expose these particles on sidewalls of the formed opening. For instance, the palladium (which is only an example) may be dispersed metallic palladium particles which coalescence together once the mold is burned by a laser. Palladium salts may be reduced to metallic palladium (nano)particles when illuminated (same as silver salts). The exposed activator particles may then allow to form a metallization in the openings or grooves by electroplating (in particular galvanic plating), to thereby form a corresponding electric entity at least partially embedded in the mold body.

In an embodiment, the method comprises forming, in particular plating, at least one electrically conductive layer structure in at least one recess in the structured mold body and/or in the further dielectric structure. In this context, it may be particularly advantageous when the mold body is made of a direct plateable mold compound (for instance comprising palladium and/or silver). In such a configuration, the plating process may be very simple, since formation of a seed layer by electroless deposition may be dispensable. When the mold compound is not directly plateable, plating may be executed by firstly forming a seed layer by electroless plating (for instance sputtering or execution of a chemical process) followed by electroplating (for instance galvanic plating).

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Also thermoplastic materials can be used, for example Polyolefins such as Polypropylene (PP), Vinyl-Polymers such as PVC, Styrene based Polymers such as Polystyrene (PS), Polyacrylates such as Polymethylmetaclylate (PMMA), Polyacetals such as Polyoxymetlylene (POM), Fluoropolymers such as Polytetrafluoroethylene (PTFE), Polyamides including aromatic polyamides such as Polyphthalamide (PPA), Polycarbonate (PC) and Derivatives, Polyesters such as Polyethylene terephthalate (PET) or Polybutlylenetherephthalate (PBT), Liquid Crystalline Polymers (LCP), Polyarylether such as Polyphenyleneether (PPE), Polyphenylenesulfone (PSU), Polyarylethersulfone (PES), Polyphenylensulfid (PPS), Polyetherketones such as Polyetheretherketone (PEEK), Polyimides (PI), Polyetherimide (PEI), Polyamidimide (PAI), Alloys or Blends of the above mentioned. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component, which can be surface mounted on the stack and/or embedded in the stack, can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs), indium phosphide (InP), and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.
Figure 1 illustrates a cross-sectional view of an electronic device according to an exemplary embodiment of the invention.
Figure 2 illustrates a cross-sectional view of an electronic device according to another exemplary embodiment of the invention.
Figure 3 to Figure 12 illustrate cross-sectional views of structures obtained during carrying out a method of manufacturing an electronic device, shown in Figure 10 and Figure 12, according to an exemplary embodiment of the invention.
Figure 13 to Figure 19 illustrate cross-sectional views of structures obtained during carrying out a method of manufacturing an electronic device, shown in Figure 19, according to another exemplary embodiment of the invention.
Figure 20 illustrates a cross-sectional view of an electronic device according to still another exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

Molded interconnect devices (MID) are devices with electrical interconnection adding electronic structures on a three-dimensional object. However, conventional MIDs do not offer high complexity in terms of structuring capabilities. Indeed, generally only one structured layer is provided in a conventional MID device.

According to an exemplary embodiment of the invention, an electronic device has a three-dimensionally non-planar mold body defining partially or entirely at least one of at least two non-planar side surfaces. Moreover, an electrically conductive structure is provided on top of a respective one of said non-planar side surfaces. Moreover, at least one electric entity is arranged partially or entirely inside of the preferably curved mold body. This may make it possible to form a flexibly designable electronic device with high functionality, in particular in molded interconnect device (MID) configuration.

In particular, an exemplary embodiment of the invention provides an electronic device configured as molded interconnect device with integrated printed circuit board. Such an integrated circuit board may be an electric entity forming part of the electronic device.

In particular, an exemplary embodiment of the invention provides an electronic device integrating an electric entity embodied as a high density integration (HDI) circuit board into a three dimensional molded interconnect device. Advantageously, this may allow to add functionality enabled by higher complexity interconnections. More specifically, it may be possible to realize a three dimensional MID with high complexity in terms of electronic circuitry, provided by component carriers or finished electronic modules embedded within the three dimensional MID body itself.

By combining one or more highly complex electronic carriers (for instance at least one PCB and/or at least one IC substrate) or highly complex electronic modules, it may be possible to achieve a much higher functionality for example in terms of sensing functions, computation capability, power management and/or communication functionality.

An exemplary embodiment provides an electronic device including a combination of materials used within a mold body: A first material may provide encapsulation as main function. A second material may provide as main function a functionalization. For instance, said functionalization may be created by laser direct structuring (LDS) and a subsequent metallization of grooves formed in the mold body by LDS. This allows to integrate a functionality with low effort.

According to exemplary embodiments, not only electronic carriers and/or electronic modules may be combined with a mold body, but a more complex and freely definable system may be created on this basis. To put it shortly, an exemplary embodiment of the invention uses MID technology to produce three dimensional structures with a conductive pattern by integrating one or more components into MID technology.

According to an exemplary embodiment of the invention, an electronic device configured as molded interconnect device with integrated electric entity (in particular a printed circuit board) is provided. In particular, one or more high density integration (HDI) circuit boards may be integrated in a three dimensional MID body in order to add functionality enabled by HDI. Furthermore, integrated HDIs may be interconnected with each other and/or with other electronic components on the surface of a three dimensional mold body.

A gist of an exemplary embodiment of the invention is to integrate within a three-dimensional mold body one or more electronic components, which may be embodied as one or more printed circuit boards or modules (i.e. a component carrier having one or more components mounted on and/or within it).

A process of integrating such a component carrier in the mold body can be overmolding, vacuum or high-pressure thermoforming or a combination of thermoforming and molding. In such a process, electronic components may be pre-fixed or assembled onto a polymeric film (as an embodiment of at least one further dielectric structure of the electronic device) holding them during the injection process. For example, such a polymeric film may be polyimide, polyethylene terephthalate (PET), polyethylene naphthalate (PEN), polycarbonate, thermoplastic polyurethane (TPU) or a layer structure combining different of the mentioned materials, for example polycarbonate-TPU-polycarbonate. A mold film based on which a mold body can be formed, may be a polymer such as polycarbonate, acrylonitrile butadiene styrene (ABS), polyphthalamide (PPA) and/or polyamide (PA).

Once the one or more component carriers are integrated within the three dimensional mold body, a laser source can be used to open or expose terminals (such as input/output (I/O) pads) of the embedded component carrier. In case the mold body contains activator particles, such as palladium, within its mold component, a laser source may expose these particles on the side walls of the opening which can then be used to deposit copper using an electrolytic bath (i.e. for metallization). In case the mold compound does not contain such an activator for metallization, an additional layer containing such an activator can be added by coating, for example by spraying, immersion, printing, etc. In case additional methods such as spraying or printing are used, it may be possible to avoid an LDS process and just leave the conductive tracks deposited by such methods. Such an additional layer may then be exposed by a laser source. The laser source may also be used to pattern the additional layer (for instance the above mentioned three dimensional mold body or the above mentioned further dielectric structure) in order to locally activate it and allow copper deposition on the activated areas. In this way, the component carrier can be connected throughout the surface with one or more other components within or above the three dimensional mold body and/or the further dielectric structure.

Interconnection of one or more electronic components may be accomplished through the polymeric film to which the one or more electronic components are fixed before molding. Additionally or alternatively, interconnection of the one or more electronic components may be realized through the three dimensional mold body.

In another embodiment, it may be possible to fix the one or more electronic components within the mold compound and form the three dimensional mold body by injection molding. The electric interconnections among electronic components can be created by printing an electrically conductive material (for instance by ink-jetting, aerosol jetting, plasma metal spraying, dispensing or other printing methods).

As an alternative to the described laser direct structuring (LDS) method for executing a three dimensional MID process, it may also be possible to execute such a three dimensional MID process by other methods, such as Microscopic Integrated Processing Technology (MIPTEC, i.e. three-dimensional injection molded circuit components using MID (Molded Interconnect Device) technology) and a two shot molding process.

Advantageously, an exemplary embodiment of the invention may provide a three dimensional MID-type electronic device with additional electric functionality provided by the above described electrically conductive structure and the at least one electric entity. Hence, even sophisticated applications concerning electronic circuitry (provided by one or more additional component carriers and/or electronic modules, as electric entity) may be provided in a three dimensionally curved mold body. In contrast to conventional approaches, the formation of an electrically conductive structure at least partially on the mold body and of at least one electric entity at least partially in the mold body may overcome functional limitations due to electronic circuitry restrictions of MID technology. By combining highly complex electronic areas (such as PCBs and/or IC substrates) and/or highly complex electronic modules, it may be possible to achieve higher functionality, for instance in terms of sending functions, computation capability, power management and/or communication functionality.

Exemplary applications of exemplary embodiments of the invention are automotive applications (such as steering wheel hubs, brake sensors, position sensors, lighting), communication applications (for instance an internal antenna of a cellular phone), telecommunications applications (for instance connectors, security shields, telecommunications boxes, etc.), or medical applications (such as portable devices, for instance glucose meters, hearing aids, and other medical applications on system level).

**Figure 1** illustrates a cross-sectional view of an electronic device 100 according to an exemplary embodiment of the invention. The electronic device 100 is manufactured in molded interconnect device (MID) technology.

As shown, the electronic device 100 comprises a three-dimensionally non-planar mold body 102. Mold body 102 is thus three dimensionally curved and is substantially U-shaped. As shown by a detail 150, mold body 102 is formed as a mold compound having different constituents. A matrix of the mold component is a mold resin 152, for instance an epoxy resin. Filler particles 154, for instance made of minerally, ceramic or technically made materials such as calcium carbonate, talc, zeolite, aluminum oxide, boron nitride, silicon dioxide, short glass fibres or hollow glass spheres, may be present in the mold resin 152. The filler particles 154 may fine-tune the properties of the mold compound, for instance may enhance thermal conductivity. For example, 50 to 90 weight percent of the mold compound may be provided by the filler particles 154. As a further constituent of the mold compound, activator particles 156 may be present in the mold compound. The activator particles 156 may for instance be palladium particles which may make it possible to directly plate metallic material on the mold compound. Hence, the mold compound of the mold body 102 may be a directly plateable mold compound. Although not shown in detail 150, one or more further additives may be present in the mold compound to further refine its properties.

Still referring to Figure 1, the electronic device 100 has an interior curved non-planar side surface 104 which has a concave shape with interior edges. Furthermore, the electronic device 100 has an opposed exterior curved non-planar side surface 106 which has a convex shape with exterior edges. In the embodiment of Figure 1, only part of the interior curved non-planar side surface 104 is defined or delimited by the mold body 102. In contrast to this, the opposed exterior curved non-planar side surface 106 of the electronic device 100 is not defined or delimited by the mold body 102, but by a further dielectric structure 116 which will be described below in further detail.

The electronic device 100 according to Figure 1 also comprises an electrically conductive structure 114 which is provided exclusively on said non-planar side surface 104 which is partially defined or delimited by the mold body 102. The electrically conductive structure 114 is a patterned metal layer applied on an exterior surface of the mold body 102 and protruding with respect to the mold body 102 inwardly. For instance, the electrically conductive structure 114 is a structured copper layer. The electrically conductive structure 114 may form one or more electrically conductive traces or a wiring structure for conducting electric signals and/or electric power. Furthermore, the electrically conductive structure 114 defines or delimits a remaining part of the non-planar interior concave side surface 104, which remaining part is not defined or delimited by the mold body 102.

Beyond this, the electronic device 100 comprises a plurality of electric entities 108, in addition to the aforementioned electrically conductive structure 114, which are embedded inside of the three-dimensionally non-planar mold body 102. The electric entities 108 comprise a plurality of embedded electronic components 110. Said electronic components 110 may comprise one or more semiconductor chips and/or may comprise one or more component carriers. For example, such an embedded semiconductor chip may comprise a processor chip, a memory chip, a logic chip, a power chip, a sensor chip, an optoelectronic chip, etc. The electric entities 108 may also comprise one or more passive components, such as at least one capacitor chip, at least one inductor chip, etc. Furthermore, an electric entity 108 may also be a module comprising a plurality of interconnected electronic components, for instance being encapsulated in a common encapsulant.

Advantageously, the electronic components 110 may also comprise one or more component carriers, such as an embedded printed circuit board (PCB) and/or an embedded integrated circuit (IC) substrate, for instance manufactured in high density integration (HDI) technology. Thus, a component carrier-type electronic component 110 can be a plate-shaped laminate-type component carrier. As indicated by a detail 160 in Figure 1, a component carrier-type electronic component 110 may comprise a laminated layer stack composed of electrically conductive layer structures 162 and one or more electrically insulating layer structures 164. As shown, the electrically conductive layer structures 162 may comprise patterned or continuous copper structures (such as layers or foils). Moreover, the electrically conductive layer structures 162 may further comprise vertical through connections, for example copper filled laser vias which may be created by plating. The one or more electrically insulating layer structures 164 may comprise a respective resin (such as a respective epoxy resin), preferably comprising reinforcing particles therein (for instance glass fibers or glass spheres). For instance, the electrically insulating layer structures 164 may be made of prepreg or FR4.

The component carrier-type electronic components 110 are, in the embodiment of Figure 1, embedded between the mold body 102 and the further dielectric structure 116.

The electric entities 108 furthermore comprise electrically conductive layer structures 114'. The electrically conductive layer structures 114' are embodied as through connections in the mold body 102 and electrically connect the embedded electronic components 110 with the electrically conductive structure 114 exposed in a protruding way on an exterior surface of the mold body 102. Holes (with circular cross-section or shaped as elongated grooves) may be filled with electrically conductive material such as copper for creating the electrically conductive layer structures 114'. The exposed electrically conductive structure 114 is electrically coupled with the embedded electronic components 110 by the embedded electrically conductive layer structures 114'. This simplifies a transmission of electric signals between the embedded electronic components 110 and an exterior of the electronic device 100, since the electrically conductive structure 114 extends up to an exposed surface of the electronic device 100.

As shown, the electronic components 110 are entirely embedded in an interior of the electronic device 100 partially covered by the mold body 102 and partially covered by the further dielectric structure 116. The embedded electrically conductive layer structures 114' are embedded in the mold body 102 only.

Now referring to the aforementioned further dielectric structure 116, the latter may be an organic dielectric layer (for instance a prepreg sheet or a resin sheet), an organic dielectric laminate (in particular a stack comprising at least two organic dielectric layers, for instance of the aforementioned type), or a further mold body (for instance made of a mold compound, which may for example have the composition shown by detail 150). The further dielectric structure 116 of Figure 1 is non-planar (in the shown embodiment substantially U-shaped). As shown, bending of the further dielectric structure 116 may follow bending of the mold body 102. According to Figure 1, the further dielectric structure 116 is connected with the mold body 102 with direct physical contact. In the embodiment of Figure 1, the further dielectric structure 116 alone defines the opposed exterior non-planar side surface 106 of the electronic device 100.

Optionally, the further dielectric structure 116 may have rigid-flexible properties or semi-flexible properties. This allows to adapt the shape of the further dielectric structure 116 to the specific needs of a certain application. It is also possible that the further dielectric structure 116 comprises a thermoplastic material, so that it can be re-shaped by temperature increase. Such material compositions of the further dielectric structure 116 may increase the freedom of a designer to freely shape the electronic device 100. Also a surface finish may be added for electrically conductive structures which are exposed at the surface.

**Figure 2** illustrates a cross-sectional view of an electronic device 100 according to another exemplary embodiment of the invention.

The embodiment according to Figure 2 differs from the embodiment of Figure 1 in particular in that, according to Figure 2, an additional surfacemounted component 118 is provided which is surface mounted above the further dielectric structure 116 and is electrically connected by the electrically conductive structure 114 and the electrically conductive layer structure 114'. In the shown embodiment, the surface mounted component 118 is electrically coupled with an embedded component 110 by the electrically conductive structure 114 and the electrically conductive layer structure 114'. For example, the at least one surface mounted component 118 may comprise a processor chip, a memory chip, a logic chip, a power chip, a sensor chip, an optoelectronic chip, a passive component (for instance a capacitor or an inductor), etc.

For example, the surface mounted electronic component 118 and the electrically coupled embedded electronic component 110 may functionally cooperate, for instance may exchange electric signals. In one embodiment, the surface mounted electronic component 118 is a processor and the embedded electronic component 110 is a memory chip. In another embodiment, the embedded electronic component 110 is a control chip and the surface mounted electronic component 118 is a sensor chip controlled by the control chip. In still another embodiment, the surface mounted electronic component 118 is an optical chip and the embedded electronic component 110 is an assigned electric chip. Other combinations of electronic components 110, 118 are however possible.

A further difference between the embodiment of Figure 2 and the embodiment of Figure 1 is that, according to Figure 2, the entire interior non-planar side surface 104 is defined or delimited by the mold body 102. In contrast to this, the opposed exterior non-planar side surface 106 of the electronic device 100 is defined partially by the further dielectric structure 116 and partially by the electrically conductive structure 114. According to Figure 2, the electrically conductive structure 114 is formed on and protruding beyond the further dielectric structure 116. Beyond this, electrically conductive layer structure 114' is embedded in the further dielectric structure 116 according to Figure 2. As in Figure 1, the electronic components 110 are embedded between the mold body 102 and the further dielectric structure 116. According to Figure 2, some electric entities 108 (in the shown example electrically conductive layer structures 114' embodied as a metallic filling of recesses of the further dielectric structure 116) are embedded inside of the further dielectric structure 116.

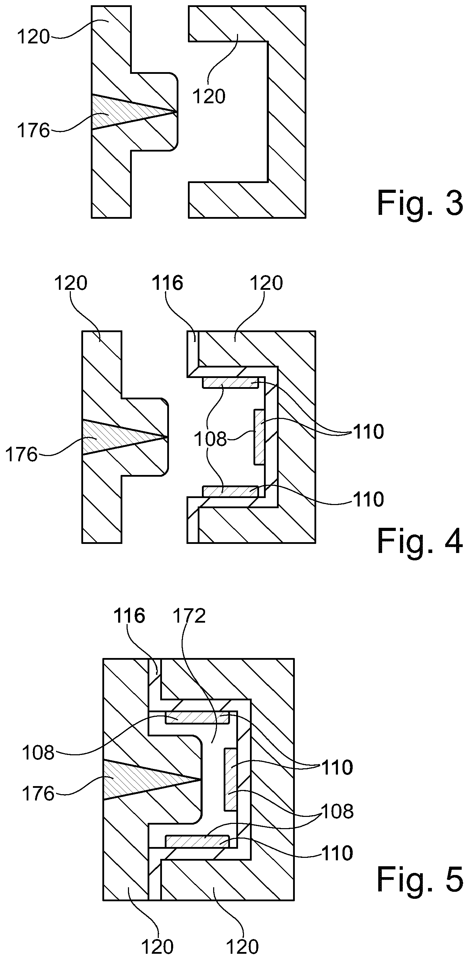

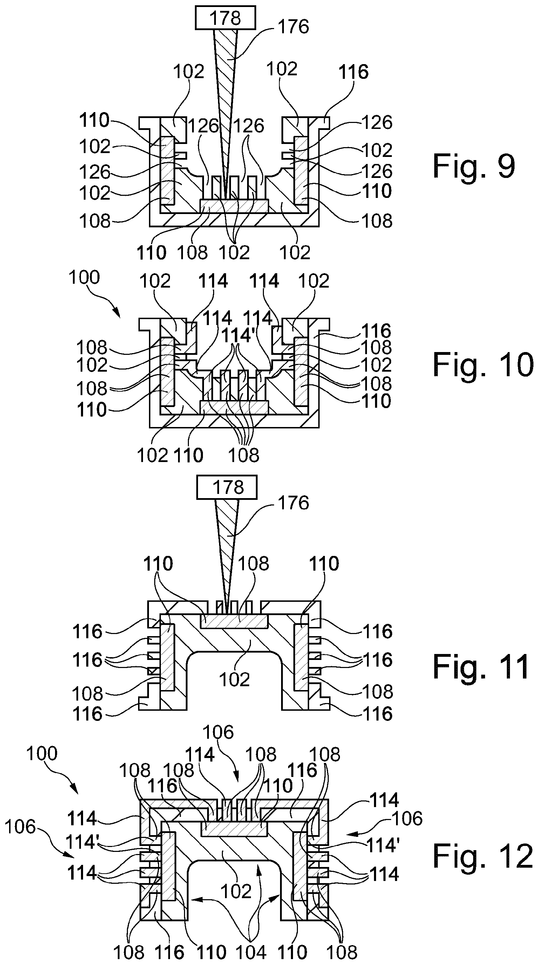

Figure 3 to Figure 12 illustrate cross-sectional views of structures obtained during carrying out a method of manufacturing an electronic device 100, shown in Figure 10 and Figure 12, respectively, according to an exemplary embodiment of the invention.

Referring to **Figure 3****,** a mold tool 120 is shown which comprises two tool parts with cooperating shape. A shape of an electronic device 100 to be manufactured using mold tool 120 is influenced by the shape of a hollow volume of a mold chamber 172 which can be delimited between the two tool parts when being converted from an opened tool configuration according to Figure 3 to a closed tool configuration according to Figure 5.

Referring to **Figure 4****,** a dielectric structure 116 is inserted in a three-dimensionally non-planar manner in the mold tool 120. The dielectric structure 116 may for instance be embodied as a still uncured flexible or bendable film or sheet. For instance, the dielectric structure 116 may be a pure resin sheet or a resin sheet comprising reinforcing particles, such as glass fibers or glass spheres. However, dielectric structure 116 may be any of a laminate (for example a prepreg laminate), a mold film, a plastic foil (for instance a thermoplastic material such as polycarbonate), etc. The bendable film or sheet-type dielectric structure 116 may be inserted in an accommodation volume of one of the tool parts so that the dielectric structure 116 is bent in accordance with a curved shape of a wall delimiting the accommodation volume of said tool part. Thereafter, electric entities 108 in form of electronic components 110 are inserted in the mold tool 120 and are attached to the dielectric structure 116 before initiating a subsequent molding process. The electronic components 110 may comprise at least one semiconductor chip and/or at least one PCB or IC substrate and/or at least one electronic module.

Referring to **Figure 5****,** the tool parts of the mold tool 120 are then closed so that the dielectric structure 116 and the attached electric entities 108 are enclosed in mold chamber 172.

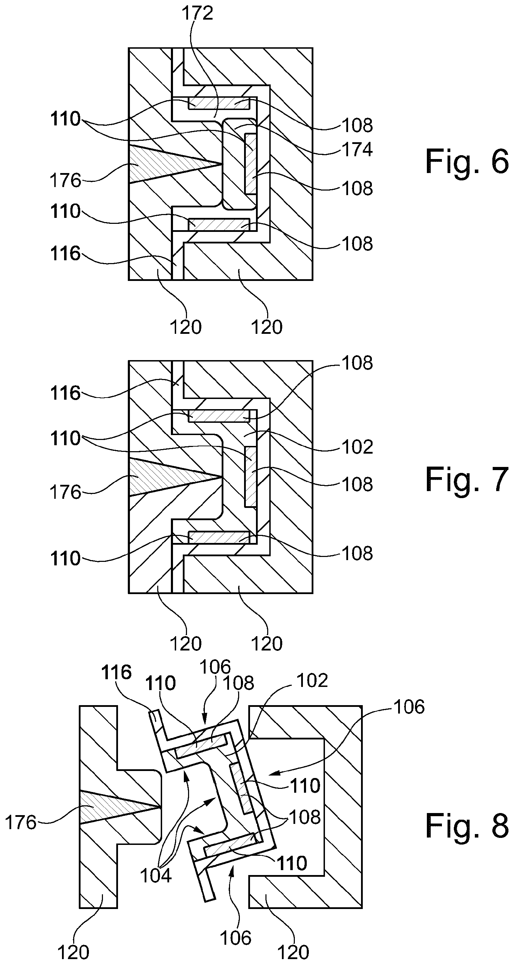

Referring to **Figure 6****,** a mold body 102 (see Figure 7) is formed in the mold tool 120 by inserting or injecting, through an injection unit 176, viscous mold material 174 (comprising a polymer) in the mold chamber 172 to thereby mold onto the further dielectric structure 116 and onto the electric entities 108. This process may be accompanied by the supply of heat and/or pressure.

Referring to **Figure 7****,** the mold material 174 (and optionally also the dielectric structure 116) is solidified by cooling. As a result, a hardened three-dimensionally non-planar mold body 102 is obtained which is integrally connected with hardened dielectric structure 116. The electric entities 108, embodied as electronic components 110, are embedded partially inside of the three-dimensionally non-planar mold body 102 and partially inside of the dielectric structure 116.

Referring to **Figure 8****,** the obtained preform of an electronic device 100 is removed from the mold tool 120 by separating the tool parts from each other. The obtained part may then be ejected from the mold tool 120. In the obtained preform, part of a non-planar side surface 104 is defined by the mold body 102, whereas an opposing further non-planar side surface 106 is defined by the dielectric structure 116.

Referring to **Figure 9****,** the mold body 102 is then structured or patterned by laser direct structuring (LDS). More specifically, recesses 126 (for instance spots and/or grooves) are formed in the exposed surface of the mold body 102 by processing with a laser beam 176 emitted by a laser source 178. As a result, pads (not shown) of the electronic components 110 are exposed. Furthermore, activator particles 156 (see Figure 1, preferably comprising palladium) of the mold body 102 may be exposed at side walls delimiting the recesses 126 by the described laser processing.

Referring to **Figure 10****,** the structure shown in Figure 9 may be subjected to a plating process to thereby form electrically conductive layer structures 114' (for example filled vias or coated vias) in the recesses 126 and an electrically conductive structure 114 on and protruding beyond part of said non-planar side surface 104. Such a metallization (preferably by a copper) may electric couple the embedded electronic components 110 with a surface of the obtained electronic device 100 shown in Figure 10. Due to the exposure of the activator particles 156 at exposed surfaces of the mold body 102 in the recesses 126, the metallization process may be carried out directly on the mold body 102. The electronic device 100 shown in Figure 10 corresponds to the embodiment of Figure 1.

As an alternative to the processing according to Figure 9 or Figure 10, the semifinished product according to Figure 8 can also be processed as described in the following referring to Figure 11 and Figure 12:
Referring to **Figure 11****,** the dielectric structure 116 is structured or patterned by laser direct structuring (LDS). More specifically, recesses 126 (for instance spots and/or grooves) are formed in the exposed surface of the dielectric structure 116 by processing with a laser beam 176 emitted by a laser source 178. As a result, pads (not shown) of the electronic components 110 are exposed.

Referring to **Figure 12****,** the structure shown in Figure 11 may be subjected to a metallization process to thereby form electrically conductive layer structures 114' in the recesses 126 and an electrically conductive structure 114 on and protruding beyond part of said opposing non-planar side surface 106. Such a metallization (preferably by a copper) may electrically couple the embedded electronic components 110 with a surface of the obtained electronic device 100 shown in Figure 12. For instance, the metallization process may comprise forming a metallic seed layer by electroless plating (for instance sputtering or a chemical process) followed by electroplating (for example galvanic plating). Metallization may also be accomplished by printing. The electronic device 100 shown in Figure 12 corresponds to the embodiment of Figure 2.

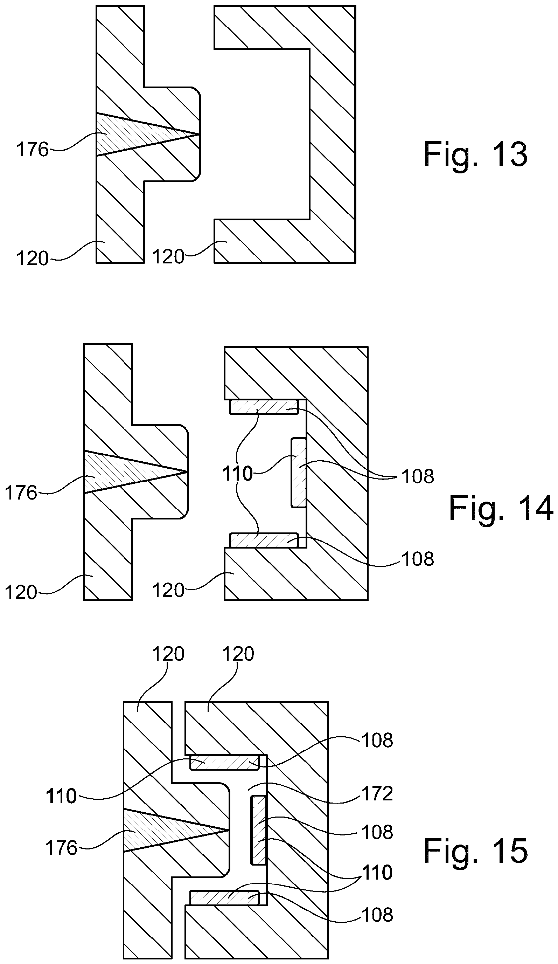

Figure 13 to Figure 19 illustrate cross-sectional views of structures obtained during carrying out a method of manufacturing an electronic device 100, shown in Figure 19, according to another exemplary embodiment of the invention. Figure 13 to Figure 19 illustrate an alternative interconnection process to interconnect electronic components 110 (such as PCBs, semiconductor chips, modules) extending up to the surface of the electronic device 100.

Referring to **Figure 13****,** a mold tool 120 is provided and opened, as described referring to Figure 3.

Referring to **Figure 14****,** a plurality of electric entities 108 embodied as electronic components 110 are inserted in different orientations in the mold tool 120. The electronic components 110 may be fixed in the mold tool 120. The electronic components 110 may comprise at least one semiconductor chip and/or at least one PCB or IC substrate and/or at least one electronic module.

Referring to **Figure 15****,** the tool parts of the mold tool 120 are closed so that the inserted electric entities 108 are enclosed in mold chamber 172.

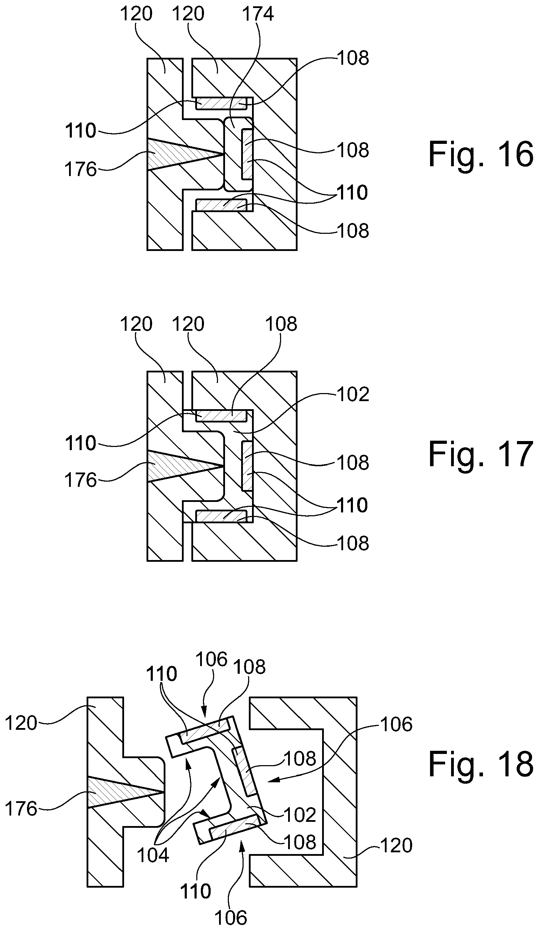

Referring to **Figure 16****,** a mold body 102 (see Figure 17) is formed in the mold tool 120 by inserting or injecting viscous mold material 174 (comprising a polymer) in the mold chamber 172 to thereby mold onto the electronic components 110.

Referring to **Figure 17****,** the mold material 174 is solidified by cooling. As a result, a hardened three-dimensionally non-planar mold body 102 is obtained which is integrally connected with the partially embedded and partially exposed electronic components 110.

Referring to **Figure 18****,** the obtained preform of an electronic device 100 is removed from the mold tool 120 by separating the tool parts from each other. The obtained part may then be ejected from the mold tool 120. In the obtained preform, non-planar side surface 104 and part of opposing further non-planar side surface 106 are defined by the mold body 102.

Referring to **Figure 19****,** after the described molding process, an electrically conductive structure 114 is applied to part of the exterior surface of the mold body 102 and is applied to an exposed pad surface of the partially embedded electronic components 110. This may be executed by printing electrically conductive material, such as copper.

**Figure 20** illustrates a cross-sectional view of an electronic device 100 according to another exemplary embodiment of the invention.

The embodiment of Figure 20 differs from the embodiment of Figure 1 in that, according to Figure 20, the mold body 120 comprises an additional exterior part covering the vast majority of the exposed surface of the dielectric structure 116. According to Figure 20, the two-component three-dimensionally non-planar mold body 102 defines part of the interior non-planar side surface 104 and part of the opposed exterior non-planar side surface 106 of the electronic device 100. At the interior non-planar side surface 104, the protruding electrically conductive structure 114 is present.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. An electronic device (100), which comprises:
a three-dimensionally non-planar mold body (102) defining at least part of one of a non-planar side surface (104) and an opposed non-planar side surface (106) of the electronic device (100);
an electrically conductive structure (114) provided on one of said non-planar side surface (104) and said opposing non-planar side surface (106); and
at least one electric entity (108) at least partially inside of the three-dimensionally non-planar mold body (102).

2. The electronic device (100) according to claim 1, wherein the at least one electric entity (108) comprises at least one electronic component (110), in particular at least one semiconductor chip and/or at least one component carrier.

3. The electronic device (100) according to any of claims 1 to 2, wherein the at least one electric entity (108) comprises at least one electrically conductive layer structure (114'), in particular a plurality of stacked electrically conductive layer structures (114').

4. The electronic device (100) according to any of claims 1 to 3, wherein the electrically conductive structure (114) extends up to an exposed surface of the electronic device (100).

5. The electronic device (100) according to any of claims 1 to 4, wherein the non-planar side surface (104) has a concave shape, and/or wherein the opposed non-planar side surface (106) has a convex shape.

6. The electronic device (100) according to any of claims 1 to 5, comprising a further dielectric structure (116).

7. The electronic device (100) according to claim 6, comprising at least one further electric entity (108) at least partially inside of the further dielectric structure (116).

8. The electronic device (100) according to any of claims 1 to 7, wherein the electrically conductive structure (114) defines at least part of only one of the non-planar side surface (104) and the opposed non-planar side surface (106) of the electronic device (100).

9. The electronic device (100) according to any of claims 1 to 8, comprising at least one of the following features:
wherein the mold body (102) comprises a resin and filler particles, and optionally palladium and/or silver;
wherein the mold body (102) is made of a directly plateable mold compound.

10. The electronic device (100) according to any of claims 1 to 9, wherein the three-dimensionally non-planar mold body (102) defines at least part of only one of the non-planar side surface (104) and the opposed non-planar side surface (106) of the electronic device (100).

11. The electronic device (100) according to any of claims 1 to 10, wherein the electrically conductive structure (114) is provided only on one of said non-planar side surface (104) and said opposing non-planar side surface (106).

12. A method of manufacturing an electronic device (100), wherein the method comprises:
forming a three-dimensionally non-planar mold body (102) defining at least part of one of a non-planar side surface (104) and an opposing non-planar side surface (106) of the electronic device (100);
forming an electrically conductive structure (114) on one of said non-planar side surface (104) and said opposing non-planar side surface (106); and
providing, preferably embedding, at least one electric entity (108) at least partially inside of the three-dimensionally non-planar mold body (102).

13. The method according to claim 12, wherein the method comprises:
inserting at least one further dielectric structure (116) in a three-dimensionally non-planar manner in a mold tool (120);
thereafter forming the mold body (102) in the mold tool (120) by molding on the further dielectric structure (116).

14. The method according to claim 12, wherein the method comprises:
inserting the at least one electric entity (108) in a mold tool (120);
thereafter forming the mold body (102) in the mold tool (120) by molding on the at least one electric entity (108).

15. The method according to any of claims 12 to 14, wherein the method comprises structuring the mold body (102) and/or structuring at least one further dielectric structure (116) on the mold body (102), in particular by laser direct structuring.
